# EUROPEAN PATENT APPLICATION

(11) **EP 4 468 205 A1**
(43) Date of publication of application: **27.11.2024**
(21) Application number: 24177982.6
(22) Date of filing: 24.05.2024
(51) Int. Cl.: G06N 3/065, G11C 11/54, G06V 10/94

(54) **PATTERN RECOGNITION SYSTEM AND METHOD USING A PAIR OF MEMRISTORS**

(30) Priority: 25.05.2023 US 202318323637
(71) Applicant: Cyberswarm, Inc, San Mateo, California 94401 (US)
(72) Inventor: DUMITRU, Viorel-Georgel, San Mateo, 94401 (US); ILIESCU, Andrei, San Mateo, 94401 (US); DUCA, Elena-Adelina, San Mateo, 94401 (US)
(74) Representative: Morrall, Jonathan Ian McLachlan

(57) **Abstract**

A pattern recognition system may include one or more pairs of memristor arrays configured to receive (i) a first set of voltage input values corresponding to a pattern on a first memristor array of a pair of memristor arrays and (ii) and a second set of voltage input values corresponding to a negative of the pattern on a second memristor array of the pair of memristor arrays, and an artificial neuron connected to each pair of memristor arrays and configured to be triggered when the pattern is recognized by a corresponding pair of memristor arrays.

## Description

### Cross Reference to Related Applications

This application is based on and derives the benefit of the filing date of United States Patent Application No. 18/323,637, filed May 25, 2023. This application is related to U.S. Patent No. 10,902,914, entitled "Programmable resistive memory element and a method of making the same," filed June 4, 2019, and issued January 26, 2021, which is hereby incorporated by reference in its entirety. This application is also related to U.S. Patent No. 11,183,240, entitled "Programmable resistive memory element and a method of making the same," filed January 26, 2021, and issued November 23, 2021, which is also hereby incorporated by reference in its entirety.

### Background

Pattern recognition is fundamental in developing artificial intelligence. Usually, pattern recognition is done with software based artificial neural networks. However, software based artificial neural networks require a lot of computational power, and also consume a lot of energy. Therefore, systems and methods that will achieve pattern recognition with much less energy consumption and that can perform local processing of data without much external computational power are highly desirable.

### Summary

A pattern recognition system and methods of training and deploying the pattern recognition system are disclosed. The pattern recognition system is based on memristor arrays and artificial neurons built with electronic components. A pattern and its negative are used for the training of a pair of memristor arrays. Multiple patterns could be trained on a memristor crossbar. Pattern recognition is done with a trained memristor array connected with an artificial neuron. The artificial neuron has an excitatory component and an inhibitory component. The excitatory component determines the triggering of the artificial neuron when the current output of one memristor array of the pair has a minimum value established during training. The inhibitory component stops the triggering of the artificial neuron when the current output of the other memristor array of the pair has a maximum value established during the training.

In an embodiment, a pattern recognition system may be provided. The system may include one or more pairs of memristor arrays configured to receive (i) a first set of voltage input values corresponding to a pattern on a first memristor array of a pair of memristor arrays and (ii) and a second set of voltage input values corresponding to a negative of the pattern on a second memristor array of the pair of memristor arrays. The system may further include an artificial neuron connected to each pair of memristor arrays and configured to be triggered when the pattern is recognized by a corresponding pair of memristor arrays.

In another embodiment, a pattern recognition method may be provided. The method may include receiving, by a pair of memristor arrays of a pattern recognition system, (i) a first set of voltage input values corresponding to a pattern on a first memristor array of a pair of memristor arrays and (ii) and a second set of voltage input values corresponding to a negative of the pattern on a second memristor array of the pair of memristor arrays. The method may also include triggering an artificial neuron connected to the pair of memristor arrays in response to the pair of memristor arrays recognizing the pattern.

In yet another embodiment, a method of training a pattern recognition system may be provided. The method may include inputting, to a pair of memristor arrays of the pattern recognition system, (i) a first set of voltage input values corresponding to a pattern on a first memristor array of a pair of memristor arrays such that the first set of voltage input values change corresponding resistances of the memristors in the first memristor array and (ii) and a second set of voltage input values corresponding to a negative of the pattern on a second memristor array of the pair of memristor arrays such that the second set of voltage input values change corresponding resistances of the memristors in the second memristor array. The method may also include configuring an artificial neuron connected to the pair of memristor arrays in response to inputting the pattern to the pair of memristor arrays.

### Brief description of the drawings

FIG 1 depicts an example pattern recognition system based on memristors and artificial neurons built with electronic components, based on the principles disclosed herein.
FIG. 2A depicts an example pattern and a corresponding negative pattern that could be used to train a pattern recognition system (e.g., pattern recognition system shown in FIG. 1), based on the principles disclosed herein.
FIGS. 2B-2C depict an example process of training a pattern recognition system using the pattern shown in FIG. 2A, based on the principles disclosed herein.
FIG. 3A depicts an example pattern and a corresponding negative pattern that could be used to train a pattern recognition system (e.g., pattern recognition system), based on the principles disclosed herein.
FIGS. 3B-3C show an example process of training a pattern recognition system using the pattern shown in FIG. 3A, based on the principles disclosed herein.
FIG. 4 depicts an example process of deploying a trained pattern recognition system, based on the principles disclosed herein.
FIG. 5 shows an example process of deploying a trained pattern recognition system, based on the principles disclosed herein. FIG. 6 shows an example process of deploying a trained pattern recognition system, based on the principles disclosed herein.

### Detailed description

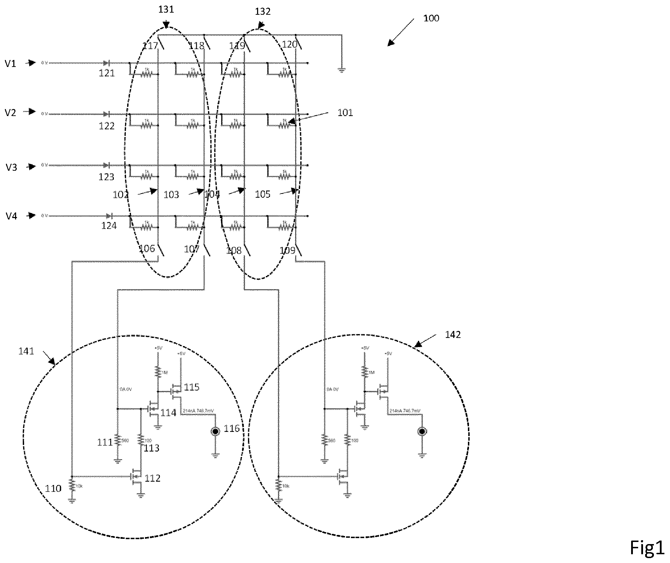

FIG. 1 depicts an example pattern recognition system 100 based on memristors and artificial neurons built with electronic components, based on the principles disclosed herein. The use of electronic components is just an example use case and should not be considered limiting. Different kinds of components, based on any kind of technology such as chemical, electrical, electrochemical, mechanical, electromechanical, etc., should also be considered within the scope of this disclosure.

Memristors 101 used in the system 100 could be different types of memristors. For instance, Indium gallium zinc oxide (IGZO) memristors with coplanar electrodes like those described in US Patent No. 10,902,914 and US Patent No. 11,183,240, both of which have been incorporated in their entirety by reference, could be used.

The memristors 101 are connected in memristors arrays 102, 103, 104, 105. The memristor arrays 102, 103, 104, 105, could be used as separated arrays or could be arranged as memristor columns in a memristor crossbar. The memristor arrays 102, 103, 104, 105 could be organized and configured in pairs to be connected to a corresponding artificial neuron. For example, memristor arrays 102, 103 could form a pair 131 of memristor arrays that could be connected with an artificial neuron 141. Similarly, memristor arrays 104, 105 could form another pair 132 of memristor arrays that could be connected with another artificial neuron 142.

While the system 100 depicted in FIG 1 has two pairs 131, 132 of memristor arrays and two artificial neurons 141, 142, each memristor array 102, 103, 104, 105 containing four individual memristors 101, it should be understood that this is only for exemplification and systems with a much large number of memristors, memristor arrays pairs, and artificial neurons could be built and operated in a similar way. That is, the specific numbers of memristors 101 for different levels of abstractions and organization (e.g., number of memristors 101 being connected to an artificial neuron) is just for an ease of explanation and should not be considered limiting.

The memristor array 102 of the pair 131 could be connected via a switch 106 with an inhibitory component of the artificial neuron 141. The inhibitory component of the artificial neuron 141 is formed by resistors 110, 113 and by transistor 112. The inhibitory component of the artificial neuron 141 could be configured to stop a triggering of the artificial neuron 141 when an output current of the memristor array 102 of the pair 131 reaches a certain maximum value established during the training process. Furthermore, the memristor array 103 of the pair 131 could be connected via a switch 107 with an excitatory component of the artificial neuron 141. The excitatory component of the artificial neuron 141 is formed by a resistor 111, and transistors 114, 115. The excitatory component of the artificial neuron 141 could be configured to trigger the artificial neuron 141 when an output current of the memristor array 103 of the pair 131 reaches a certain minimum value established during the training process. The triggering of the artificial neuron 141 means that the transistor 115 is open and thus a current is flowing through an indicator 116, thereby turning it on. It should be also noted that the indicator 116 could be replaced by the connection (e.g., to send an indication of the triggering) to the next layer of a hardware based neural network in which the pattern recognition system 100 could be a layer for feature recognition.

Similarly, a switch 108 could connect the memristor array 104 with an inhibitory component of the artificial neuron 142 and a switch 109 could connect the memristor array 105 with an excitatory component of the neuron 142. The inhibitory component and the excitatory component of the artificial neuron 142 could be analogous to the corresponding components in the artificial neuron 141.

Also, each of the memristor arrays 102, 103, 104, 105 could be connected separately directly to a ground via corresponding switches 117, 118, 119, 120.

A first memristor 101 of each array 102, 103, 104, 105could form a first line of a crossbar connected via a diode 121 to a power supply V1. Similarly, the second, the third, and the fourth memristors of each array could be connected via the diodes 122, 123, 124 to the corresponding power supplies V2, V3, V4.

It should be noted, as described above, that the way in which are built both the excitatory and the inhibitory parts of the neurons shown here are only for exemplification and other components (for instance, potentiometers instead of fixed resistors or different kinds of transistors, etc.) could be also used for obtaining the excitatory and inhibitory functions described herein. Also, instead the switches, other type of control units that may cause the respective connections interruption could be used (for instance, transistors, etc.).

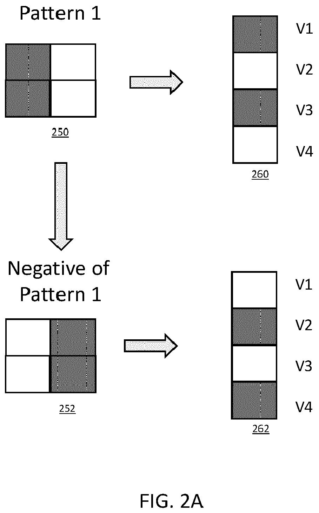

The pattern recognition system could be trained to recognize different patterns. In some example embodiments, the training could include inputting an example pattern and a negative of the example pattern. For example, FIG. 2A depicts an example pattern 250 and a corresponding negative pattern 252 that could be used to train a pattern recognition system (e.g., pattern recognition system 100) , based on the principles disclosed herein.

To train the pattern recognition system, the pattern 250 and the corresponding negative pattern 252 could be divided into parts or pixels, which could then be transformed in voltage input vectors 260, 262, respectively.

In one or more embodiments, the voltage input vectors 260, 262 may be scaled up in order to obtain voltage values high enough to change the resistance of the memristors (e.g., memristors 101). For example, when the voltage input vectors 260, 262 are applied on a pair (e.g., pair 131) of the memristor arrays, the pattern recognition system will be trained to recognize the respective pattern 250.

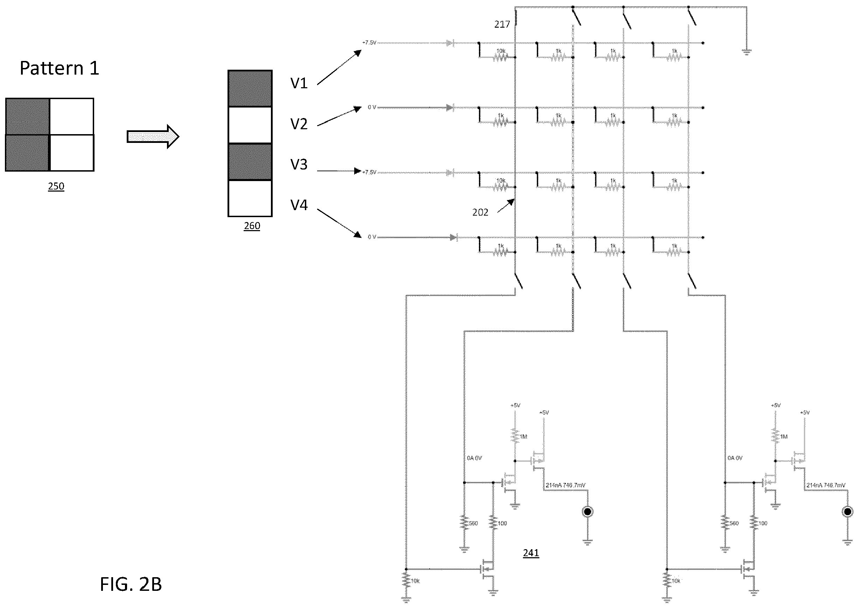

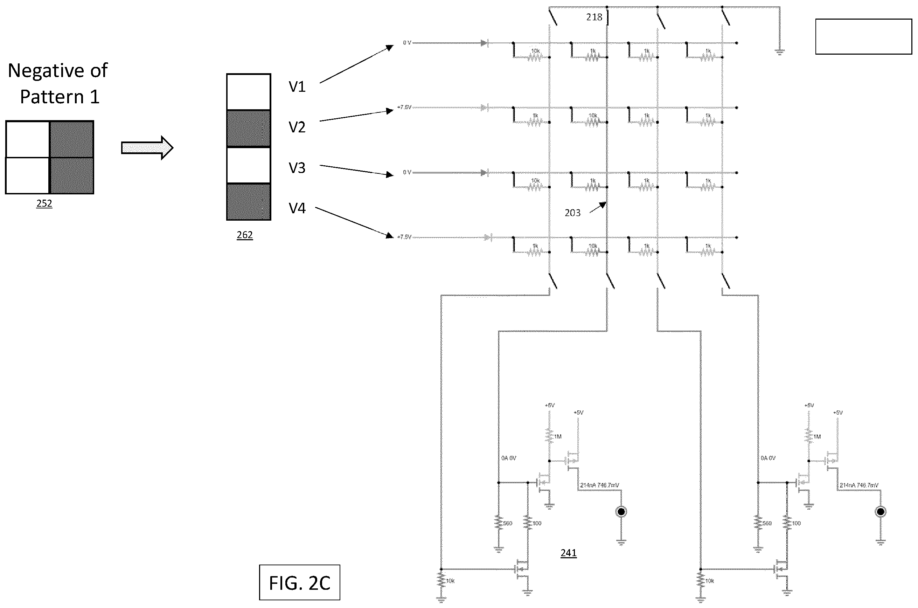

FIGS. 2B-2C depict an example process of training a pattern recognition system using the pattern 250 shown in FIG. 2A, based on the principles disclosed herein. As shown, the pattern 250 could be divided into pixels, which are then transformed into voltage input vectors 260. In some cases, an application of a high voltage could increase a memristor's resistance. In these cases, the high voltage values (V1, V3) corresponding to the pattern 250 are applied on the memristor array 202 associated with an inhibitory component of an artificial neuron 241, as shown in FIG. 2B. Additionally and as shown in FIG. 2C, the high voltage values (V2, V4) corresponding to the negative pattern 252 of the pattern 250 are applied on a memristor array 203 associated with an excitatory component of the artificial neuron 241.

Conversely, in some cases, an application of high voltage values could decrease a memristor's resistance. In these cases the high voltage values (V1, V3) corresponding to the pattern 250 are applied on the memristor array 202 associated with the excitatory component of the artificial neuron 241 and the high voltage values (V2, V4) corresponding to the negative 252 of the pattern 250 are applied on the memristor array 203 associated with the inhibitory component of the artificial neuron 241. Although the memristors' resistances may increase or decrease in response an application of high voltage values, the example below-for the sake of brevity and ease of explanation-describe the use cases where the memristors' resistances increase in response to the application of the high voltage values.

As depicted in FIG. 2B, by applying the high voltage values corresponding to the pattern 250 on the memristor array 202 and closing the switch 217, a current will flow through the first and the third memristors (counting from the ground) of the memristor array 202 increasing their corresponding resistances.

As depicted in FIG 2C, by applying the high voltage values corresponding to the negative 252 of the pattern 250 on the memristor array 203 and closing the switch 218, a current will flow through the second and the fourth memristors (counting from the ground) of the memristor array 203 increasing their corresponding resistances.

In this way one pair of memristor arrays (in this case the first pair, e.g., pair 131 shown in FIG. 1) could be trained to recognize the pattern 250. Pattern 250 is just an example, and the crossbar configuration of memristor pairs, different types of patterns could be learned. That is, additional patterns could be learned using additional memristor pairs on the same crossbar.

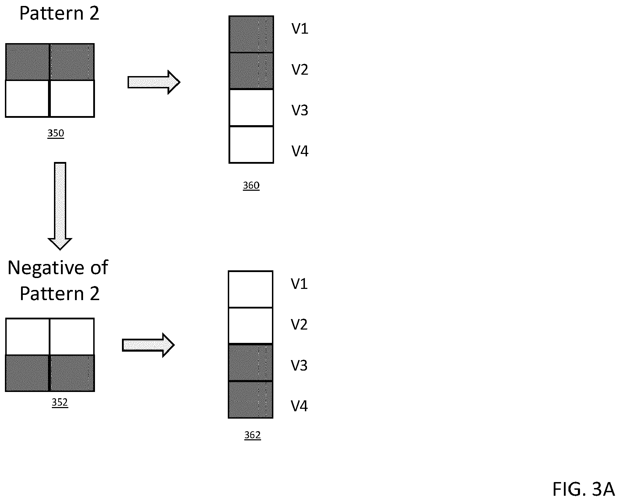

For example, FIG. 3A depicts an example pattern 350 and a corresponding negative pattern 352 that could be used to train a pattern recognition system (e.g., pattern recognition system 100), based on the principles disclosed herein. The training could be performed using a second pair of memristors arrays (e.g., pair 132 shown in FIG. 1) For this, the same procedure like for learning the pattern 250 (as shown in FIG. 2A) could be used. The pattern 350 and the negative 352 of the pattern 350 may be divided in parts or pixels that are then transformed in voltage input vectors 360, 362, respectively. The voltage input vectors 360, 362 could be scaled up in order to obtain voltage values high enough to change the memristors resistance and are applied on the second pair of memristor arrays (e.g., pair 132 as shown in FIG. 1) that could be trained to recognize the pattern 350.

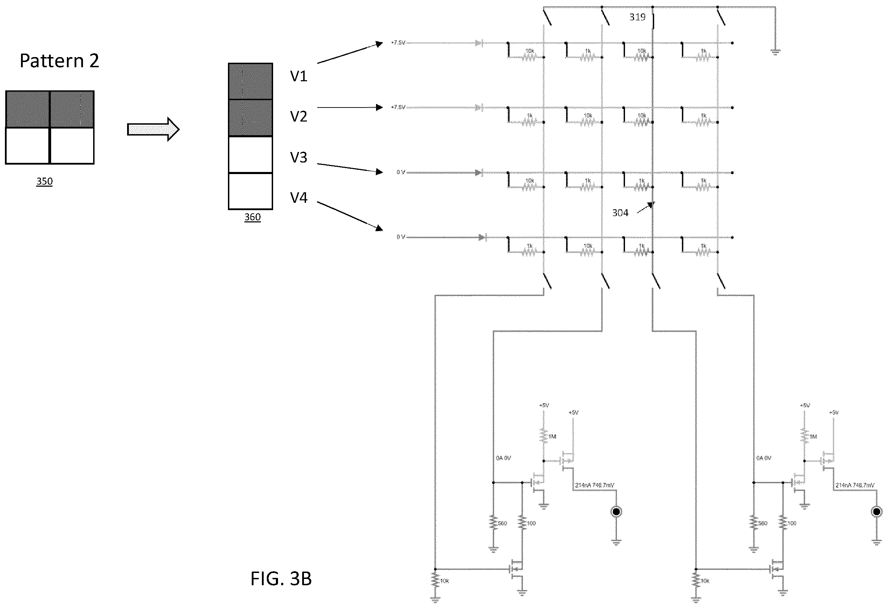

FIGS. 3B-3C show an example process of training a pattern recognition system using the pattern 350 shown in FIG. 3A, based on the principles disclosed herein. For example, as depicted in FIG 3B, by applying the high voltage values (V1, V2) corresponding to the pattern 350 on the memristor array 304 and closing the switch 319, current will flow through the first and the second memristors (counting from the ground) of the memristor array 304 increasing their corresponding resistances.

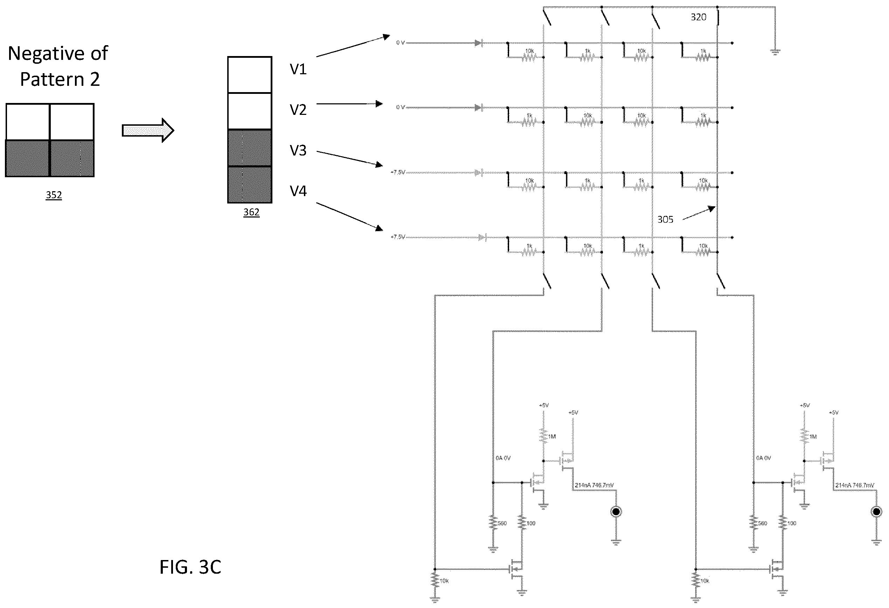

As depicted in FIG 3C, by applying the high voltage values (V3, V4) corresponding to the negative 352 of pattern 350 on the memristor array 305 and closing the switch 320, current will flow through the third and the fourth memristors (counting from the ground) of the memristor array 305 increasing their corresponding resistances.

Therefore, using the principles disclosed herein, the pattern recognition system could be trained to recognize different patterns, using for each pattern a pair of memristor arrays and its associate neuron.

After a pattern recognition system is trained, the trained system could be deployed to recognize patterns. For recognizing a certain pattern, the respective pattern is divided in parts or pixels that are then transformed in voltage input vectors similar to the ones used during the training processes, but now the voltage input vectors are scaled down to get voltage values low enough in order not to change the memristor resistances. Then the voltage input vectors corresponding to respective pattern are applied on all the memristor array pairs, each pair being connected with its associate neuron. If the respective pattern corresponds to one which a pair of memristor arrays was trained to recognize, its associate neuron will be triggered and its indicator (e.g., indicator 116 shown in FIG. 1) will turn on.

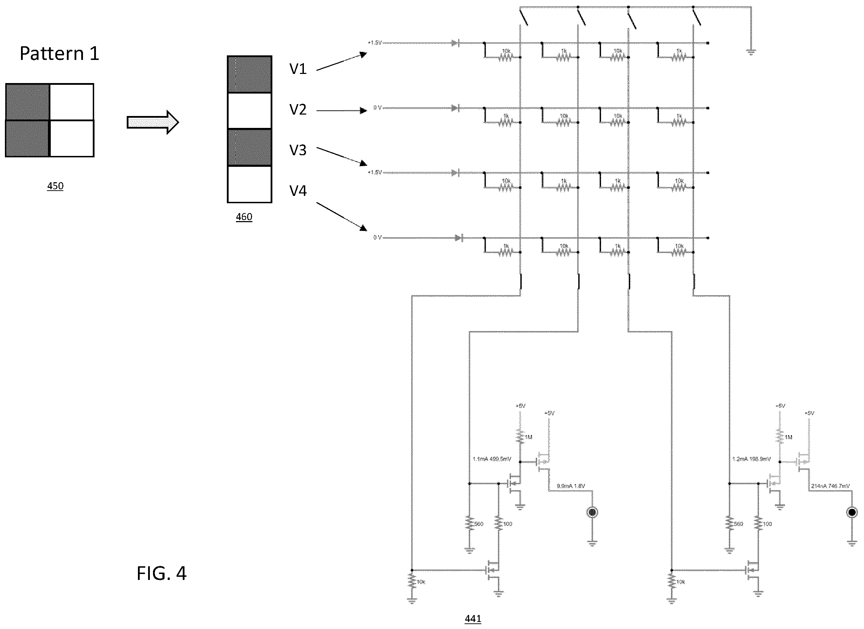

FIG. 4 depicts an example process of deploying a trained pattern recognition system, based on the principles disclosed herein. As shown, the trained pattern recognition system could recognize pattern 450 (similar to pattern 250 shown in FIGS. 2A-2C). Particularly, a voltage input vector 460 could be generated from the pattern 450. The voltage input vector 460 could include voltages V1 (high), V2 (low), V3 (high), V4 (low), which are lower than the corresponding training vectors so as to not change the resistances of the trained memristors. As shown in from FIG 4, the artificial neuron 441 associated with the first pair of memristor array, that was trained to recognize the pattern 250, is triggered and turns on its indicator.

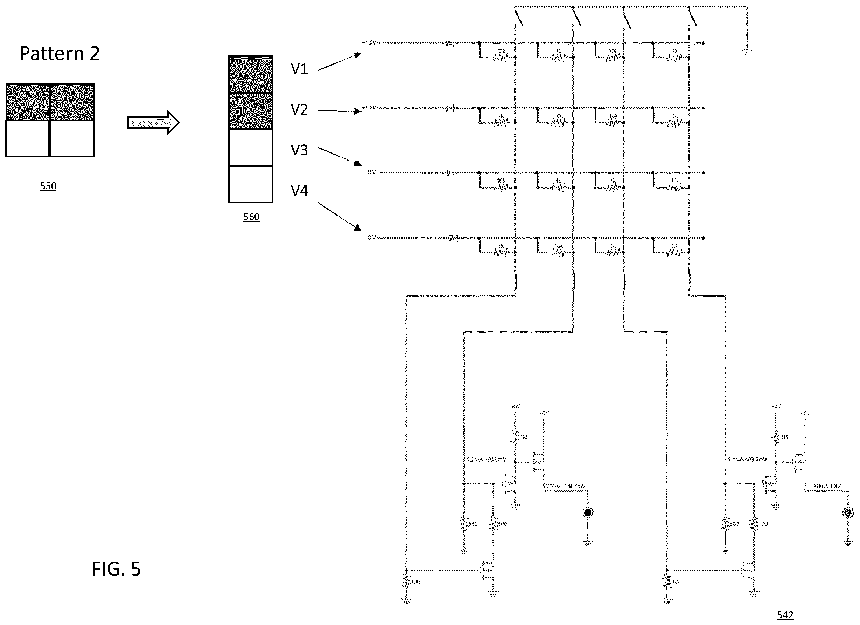

FIG. 5 shows an example process of deploying a trained pattern recognition system, based on the principles disclosed herein. As shown, the trained pattern recognition system could recognize pattern 550 (similar to pattern 350 shown in FIGS. 3A-3C). As could be seen, the artificial neuron 542 associated with the second pair of memristor array, that was trained to recognize the 552 (or 352), is triggered and turns on its indicator.

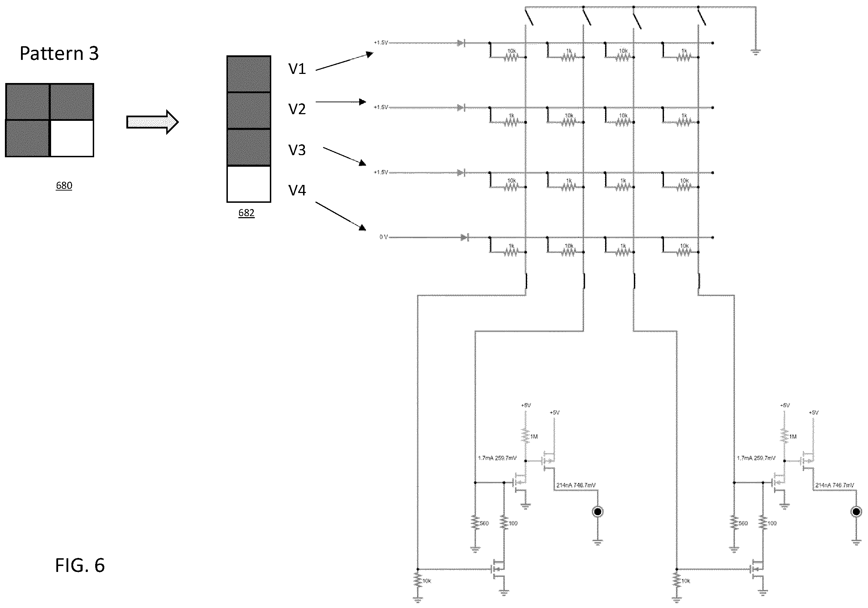

In some cases, the trained pattern recognition system may receive a pattern that system has not been trained to recognize. In such cases, no artificial neuron will be triggered and all the indicators will be off. For example, FIG. 6 shows an example process of deploying a trained pattern recognition system, based on the principles disclosed herein. Particularly, a pattern 680-that the pattern recognition has not been trained for-is used to generate a voltage input vector 682 with voltages V1 (high), V2 (high), V3 (high), V4 (low). The pattern 680, however, is different from the patterns 250, 350 that the pattern recognition system was trained to recognize. Therefore, the pattern recognition system could not be able to recognize the pattern 680, no artificial neurons will be activated, and no signals will be turned on.

It should be noted also that while the described patterns 250, 350 only black and white pixels, and thus the corresponding voltage vector inputs had only two values, the disclosed system and operating method could also be used with patterns having grey-scale pixels (or multi-level pixels in general) in which case the voltage vector values would have many different voltage values. For example, memristors with multiple states, preferably analog states, may be used.

Additional examples of the presently described method and device embodiments are suggested according to the structures and techniques described herein. Other non-limiting examples may be configured to operate separately or can be combined in any permutation or combination with any one or more of the other examples provided above or throughout the present disclosure.

It will be appreciated by those skilled in the art that the present disclosure can be embodied in other specific forms without departing from the spirit or essential characteristics thereof. The presently disclosed embodiments are therefore considered in all respects to be illustrative and not restricted. The scope of the disclosure is indicated by the appended claims rather than the foregoing description and all changes that come within the meaning and range and equivalence thereof are intended to be embraced therein.

It should be noted that the terms "including" and "comprising" should be interpreted as meaning "including, but not limited to". If not already set forth explicitly in the claims, the term "a" should be interpreted as "at least one" and "the", "said", etc. should be interpreted as "the at least one", "said at least one", etc. Furthermore, it is the Applicant's intent that only claims that include the express language "means for" or "step for" be interpreted under 35 U.S.C. 112(f). Claims that do not expressly include the phrase "means for" or "step for" are not to be interpreted under 35 U.S.C. 112(f).

## Claims

1. A pattern recognition system comprising:
one or more pairs of memristor arrays configured to receive (i) a first set of voltage input values corresponding to a pattern on a first memristor array of a pair of memristor arrays and (ii) and a second set of voltage input values corresponding to a negative of the pattern on a second memristor array of the pair of memristor arrays, ; and
an artificial neuron connected to each pair of memristor arrays and configured to be triggered when the pattern is recognized by a corresponding pair of memristor arrays.

2. The system of claim 1, the memristor arrays being arranged as memristor columns in a memristor crossbar.

3. The system of claim 2, the artificial neuron comprising:
an excitatory component configured to determine the triggering of the artificial neuron when a current output of one memristor array of the pair has a minimum value established during training; and
an inhibitory component configured to stop the triggering of the artificial neuron when a current output of the other memristor array of the pair has a maximum value established during the training.

4. The system of any preceding claim, the memristors comprising Indium gallium zinc oxide (IGZO) based memristors, or/and optionally the memristors having electrodes on a same plane.

5. The system of any preceding claim, the triggering of the artificial neuron comprising:
turning on an indicator on the artificial neuron; or
sending an indication of the triggering to a next layer of the pattern recognition system.

6. The system of any preceding claim, the pattern comprising pixels, and each voltage input value corresponding to a state of the pixels.

7. The system of claim 6, wherein:
the pixels being binary, and each voltage input value being either a high voltage input value or a low voltage input value; or
the pixels being multi-level, each voltage input value corresponding to a level of the corresponding pixel.

8. A pattern recognition method, comprising:
receiving, by a pair of memristor arrays of a pattern recognition system, (i) a first set of voltage input values corresponding to a pattern on a first memristor array of a pair of memristor arrays and (ii) and a second set of voltage input values corresponding to a negative of the pattern on a second memristor array of the pair of memristor arrays; and
triggering an artificial neuron connected to the pair of memristor arrays in response to the pair of memristor arrays recognizing the pattern.

9. The method of claim 8, the first memristor array and the second memristor array being arranged as memristor columns in corresponding memristor crossbars.

10. The method of claim 8 or 9, further comprising:
- triggering, by an excitatory component of the artificial neuron, artificial neuron when a current output of one memristor array of the pair has a minimum value established during training; and
- stopping the triggering, by an inhibitory component of the artificial neuron, of the artificial neuron when a current output of the other memristor array of the pair has a maximum value established during the training.

11. The method of any of claims 8 to 10, the memristors comprising Indium gallium zinc oxide (IGZO) based memristors, or/and optionally the memristors having electrodes situated on a same plane.

12. A method of training a pattern recognition system, the method comprising:
inputting, to a pair of memristor arrays of the pattern recognition system, (i) a first set of voltage input values corresponding to a pattern on a first memristor array of a pair of memristor arrays such that the first set of voltage input values change corresponding resistances of the memristors in the first memristor array and (ii) and a second set of voltage input values corresponding to a negative of the pattern on a second memristor array of the pair of memristor arrays such that the second set of voltage input values change corresponding resistances of the memristors in the second memristor array; and
configuring an artificial neuron connected to the pair of memristor arrays in response to inputting the pattern to the pair of memristor arrays.

13. The method of claim 12, the first memristor array and the second memristor array being arranged as memristor columns in corresponding memristor crossbars.

14. The method of claim 12 or 13, the configuring the artificial neuron comprising:
- configuring, an excitatory component of the artificial neuron, to trigger the artificial neuron when a current output of one memristor array of the pair has a minimum value; and
- configuring, an inhibitory component of the artificial neuron, to stop the triggering of the artificial neuron when a current output of the other memristor array of the pair has a maximum value.

15. The method of any of claims 12 to 14, the memristors comprising Indium gallium zinc oxide (IGZO) based memristors, or/and optionally the memristors having electrodes situated on a same plane.
